# EUROPEAN PATENT APPLICATION

(11) **EP 3 758 228 A1**
(43) Date of publication of application: **30.12.2020**
(21) Application number: 20182097.4
(22) Date of filing: 24.06.2020
(51) Int. Cl.: H03K 17/12, H03K 17/16

(54) **ELECTRICAL POWER SWITCHING CIRCUITS**

(30) Priority: 25.06.2019 US 201916451404
(71) Applicant: EnerSys Delaware Inc., Reading, PA 19605 (US)
(72) Inventor: MARZOUGHI, Alinaghi, Sinking Spring, PA Pennsylvania 19608 (US)
(74) Representative: Abel & Imray

(57) **Abstract**

An electrical power switching circuit (200) comprising a plurality of field effect transistors (FETs) (201a, 201b, 201c) connected in a parallel configuration. Each FET in the plurality of FETs comprises a gate pin (202a, 202b, 202c). The electrical power switching circuit comprises a plurality of control stages (203a, 203b, 203c). Each control stage in the plurality of control stages is associated with a FET in the plurality of FETs. Each control stage in the plurality of control stages comprises a gate pin connection (204a, 204b, 204c). The gate pin of each FET in the plurality of FETs is connected to the gate pin connection of a respective control stage. Power supplied to each control stage in the plurality of control stages is decoupled from power supplied to each other control stage in the plurality of control stages.

## Description

### Technical Field

The present disclosure concerns electrical power switching circuits. More particularly, but not exclusively, the present disclosure concerns a plurality of field effect transistors (FETs) connected in a parallel configuration and a plurality of control stages.

### Background

A field effect transistor (FET) is a type of transistor that controls flow of current between its drain and source pins depending on the voltage applied to its gate pin. The voltage present at the gate pin controls the flow of current by varying the conductivity of the semiconductor material between its drain and source pins.

FETs can be categorised into enhancement mode FETs and depletion mode FETs. Enhancement mode FETs block current flow between the drain and source pins until a gate-source voltage is applied that is large enough to 'turn on' the FET. Conversely, depletion mode FETs allow current flow between the drain and source pins until a large enough gate-source voltage is applied to 'turn off' the FET. Enhancement mode FETs can be considered as normally open switches and depletion mode FETs can be considered as normally closed switches.

A metal oxide semiconductor FET (MOSFET) is a FET in which the gate pin is electrically insulated from the main current carrying channel by an insulating layer. Traditionally, the insulating layer was comprised of a metal oxide, but other insulating materials are common.

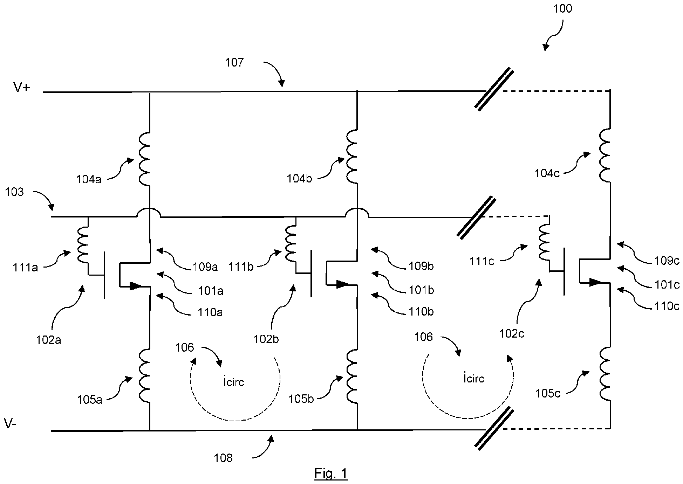

FETs have a maximum current rating, specifying the maximum current that can safely flow through the device. In order to conduct more current, two or more similar FETs can be connected in parallel, and the current shared between them. Figure 1 shows a circuit 100 in which a plurality of FETs 101a, 101b, 101c are connected in parallel. For simplicity, only three FETs are shown, but it is to be understood that more or fewer may be used. The drain pins 109a, 109b, 109c of the plurality of FETs are connected to a common drain rail 107, and the source pins 110a, 109b, 109c of the plurality of FETs are connected to a common source rail 108.

Each gate pin 102a, 102b, 102c of the plurality of FETs is connected to a common gate rail 103 such that all the FETs in the plurality can be controlled together by a voltage applied to the common gate rail 103. When a voltage is present on the common gate rail 103 that is lower than the turn on voltage of the plurality of FETs, the FETs in the plurality will be non-conductive and no current will flow between the drain rail and the source rail. Upon increasing the voltage present on the common gate rail 103 from below the turn on voltage to above the turn on voltage of the FETs in the plurality, the plurality of FETs will become conductive and current may flow from the common drain rail 107 to the common source rail 108 in parallel through the plurality of FETs. In this manner, the plurality of FETs can be considered to be turned on.

When the voltage on the common gate input falls from above the turn on voltage to below the turn on voltage, the plurality of FETs will become non-conductive and current will cease to flow between the drains and sources of the plurality of FETs. In this manner the plurality of FETs can be considered to be turned off.

Turning on or turning off a FET is commonly referred to as a 'switching' operation.

Each FET in the plurality further comprises a parasitic drain inductance 104a, 104b, 104c associated with its drain pin 109a, 109b, 109c, and a parasitic source inductance 105a, 105b, 105c associated with its source pin 110a, 110b, 110c, and a parasitic gate inductance 111a, 111b, 111c associated with its gate pin 102a, 102b, 102c. The parasitic inductances comprise inductances inherent in the FET device and/or inductances inherent in the electrical connections and wiring of the circuit.

Schematically, each parasitic inductance can be represented as a single inductor connected to the respective pins of each of the plurality of FETs. Figure 1 shows parasitic drain inductors 104a, 104b, 104c connected in a series configuration with the respective drain pins of each FET in the plurality, and parasitic source inductors 105a, 105b, 105c connected in a series configuration with the respective source pin of each FET in the plurality.

It is desirable to ensure that the current flowing through each parallel FET in the plurality is approximately equal to avoid any single FET in the plurality or subset of FETs in the plurality, conducting current at, or near, its current limit and potentially overheating or otherwise becoming damaged, while other FETs in the plurality are below their current limit. Further, it is desirable to equalize the current flowing in a plurality of parallel FETs during switching events, where switching higher currents in a FET or subset of FETs in the plurality will cause higher switching stress on the FET or subset of FETs, as discussed below. Equalizing current flow through each parallel FET in the plurality allows for greater overall current ratings of the parallel FET circuit before such damage occurs.

When a FET is in a non-conducting state, the voltage across the drain and source pins of the FET (the drain-source voltage) is at a maximum value and current is not conducted between the drain and source pins. In this non-conducting state, no power is dissipated by the FET.

When a FET is in a conducting state, the drain-source voltage of the FET is a minimum value and current is conducted through the FET. In this conducting state, power is dissipated by the FET, often referred to as 'conduction losses'.

When transitioning from a non-conducting state to a conducting state (switching on), or transitioning from a conducting state to a non-conducting state (switching off) energy is dissipated by the FET to perform the switching operation. Such energy dissipation during switching is often referred to as 'switching losses' and can be substantial in high switching frequency systems. Switching losses in a FET depend directly on the drain-source voltage of the FET, the switching time of the FET and the drain-source current of the FET.

In a system with a plurality of FETs connected in parallel, the drain-source voltage of each FET in the plurality is the same, and it is common to use multiple FETs of the same type to minimise differences in switching times. As such, different drain-source currents in the FETs in the plurality may cause significant differences in the switching losses in each FET in the plurality. FETs that dissipate higher switching losses by conducting higher drain-source currents while switching are likely to fail before FETs that conduct lower drain-source currents while switching. It is desirable to balance switching losses between FETs in a plurality of FETs connected in parallel to minimise the likelihood of a FET or subset of FETs in the plurality dissipating substantially more energy than others and failing over time.

In order to share the current flowing through each parallel FET in the plurality approximately equally when all FETs in the plurality are conducting or switching, a first design constraint, requiring that the impedance of each parallel path should be approximately equal, is introduced. As such, it is useful to balance the parasitic inductances of each parallel electrical path through each parallel FET in the plurality such that the sum of the drain and source inductances of each parallel path are the same.

Further, where a plurality of FETs are connected in a parallel configuration, if the parasitic source inductances of the FETs in the plurality 105a, 105b, 105c are unequal, circulating currents 106 may flow when turning off the plurality of FETs. A known consequence of such circulating currents is the unintended generation of voltages at the gate pins 102a, 102b, 102c of the FETs in the plurality and unintended turn on of FETs in the plurality following a turn off event. In order to prevent circulating currents 106 flowing during turn off events, a second design constraint is introduced, wherein it is desirable to balance the parasitic inductances of the source paths such that all parasitic source inductances 105a, 105b, 105c are equal.

To meet the above-mentioned first and second design constraints the circuit 100 of Figure 1 requires that the values of parasitic drain inductances all be equal (104a = 104b = 104c), and that the values of parasitic source inductances all be equal (105a = 105b = 105c).

A known prior art method of balancing the inductances of such circuits when mounted on a printed circuit board (PCB) includes lengthening the conductive trace to which each FET in the plurality connects. PCB traces typically have a parasitic inductance of approximately 1nH/cm and balancing drain and/or source pin inductances may require lengthening traces by several centimetres.

The traces of a PCB may need to be lengthened to balance the impedances for equal current sharing, which may cause switching oscillations and limit switching speeds. Such lengthening increases the complexity of the design of parallel FET circuits and imposes geometrical limits on PCB mounted parallel FET circuits.

The present disclosure seeks to mitigate the above-mentioned problems.

### Summary

The present disclosure provides, according to a first aspect, an electrical power switching circuit comprising a plurality of field effect transistors, FETs, connected in a parallel configuration, each FET in the plurality of FETs comprising a gate pin. The circuit further comprises a plurality of control stages, each control stage in the plurality of control stages being associated with a FET in the plurality of FETs, each control stage in the plurality of control stages comprising a gate pin connection, wherein the gate pin of each FET in the plurality of FETs is connected to the gate pin connection of a respective control stage, wherein power supplied to each control stage in the plurality of control stages is decoupled from power supplied to each other control stage in the plurality of control stages.

The present disclosure provides, according to a second aspect, a method of manufacturing an electrical power switching circuit, the method comprising: forming a plurality of field effect transistors, FETs, in a parallel configuration, each FET in the plurality of FETs comprising a gate pin; forming a control stage to each FET in the plurality of FETs, each control stage comprising a gate pin connection; and connecting the gate pin of each FET in the plurality of FETs to the gate pin connection of a respective control stage, wherein each control stage comprises a power decoupling portion to decouple power supplied to it each control stage from power supplied to each other control stage.

The present disclosure provides, according to a third aspect, a solid state relay comprising a plurality of field effect transistors, FETs, connected in a parallel configuration, each FET in the plurality of FETs comprising a gate pin. The circuit further comprises a plurality of control stages, each control stage in the plurality of control stages being associated with a FET in the plurality of FETs, each control stage in the plurality of control stages comprising a gate pin connection, wherein the gate pin of each FET in the plurality of FETs is connected to the gate pin connection of a respective control stage, wherein power supplied to each control stage in the plurality of control stages is decoupled from power supplied to each other control stage in the plurality of control stages.

It will of course be appreciated that features described in relation to one aspect of the present disclosure may be incorporated into other aspects of the present disclosure. For example, the method of the disclosure may incorporate any of the features described with reference to the apparatus of the disclosure and *vice versa.*

### Brief Description of the Drawings

Embodiments of the present disclosure will now be described by way of example only with reference to the accompanying schematic drawings of which:
Figure 1 shows a schematic of a known parallel FET circuit;
Figure 2 shows a schematic view of a circuit according to embodiments of the present disclosure;
Figure 3a shows a schematic view of a subsection of the circuit of Figure 2 according to embodiments of the present disclosure;
Figure 3b shows a schematic view of a subsection of the circuit of Figure 2 according to embodiments of the present disclosure;
Figure 4 shows a schematic view of a circuit according to embodiments of the present disclosure;
Figure 5 shows a schematic PCB layout of a circuit according to embodiments of the present disclosure; and
Figure 6 shows a flow chart illustrating the steps of a method according to embodiments of the present disclosure.

### Detailed Description

The following description of embodiments is made in reference to enhancement mode FETs, but it will be understood by those skilled in the art that in other embodiments the same/similar principles could also be applied to depletion mode FETs.

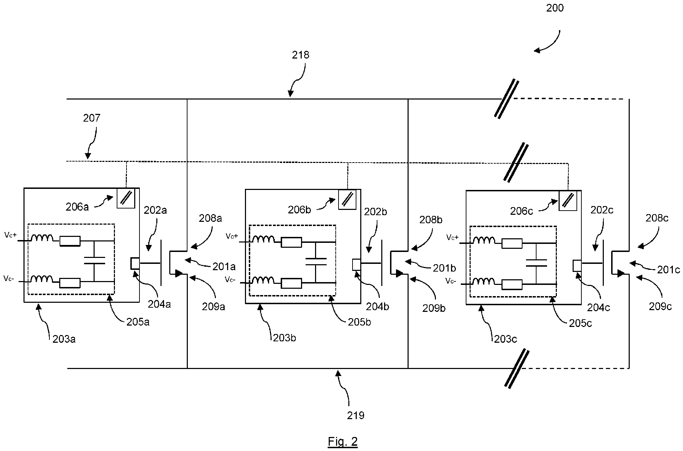

Figure 2 shows a schematic view of an electrical power switching circuit 200 according to embodiments of the present disclosure.

Circuit 200 comprises a plurality of FETs 201a, 201b, 201c connected in a parallel configuration. Each FET in the plurality comprises respectively a gate pin 202a, 202b, 202c, a drain pin 208a, 208b, 208c, and a source pin 209a, 209b, 209c. Circuit 200 further comprises a plurality of control stages 203a, 203b, 203c, each control stage being associated with a FET in the plurality of FETs. Each control stage comprises a gate pin connection 204a, 204b, 204c. The gate pin of each FET in the plurality of FETs is connected to the gate pin connection of a respective control stage.

The gate pins 202a, 202b, 202c of each FET in the plurality connect to the gate pin connections 204a, 204b, 204c of a respective control stage 203a, 203b, 203c such that the gate pin of each FET in the plurality connects to its own respective control stage. For simplicity, only three FETs and control stages are shown in Figure 2, but it will be understood by one skilled in the art that the circuit may contain more or fewer FETs and control stage pairings.

In embodiments, the drain pins 208a, 208b, 208c of the FETs in the plurality connect to a common drain rail 218, and the source pins 209a, 209b, 209c of the FETs in the plurality connect to a common source rail 219.

In embodiments, each control stage in the plurality of control stages 203a, 203b, 203c comprises a power decoupling portion 205a, 205b, 205c. The power decoupling portion decouples the power supplied to each control stage from the power supplied to each other control stage. In embodiments, each power decoupling portion comprises a power supply capacitor to provide a switching power to a respective control stage.

In embodiments, each control stage in the plurality of control stages 203a, 203b, 203c is configured to receive a control signal. Each control stage in the plurality of control stages 203a, 203b, 203c is configured to provide a switching voltage at the gate pin of its associated FET in the plurality of FETs upon receipt of the control signal.

In embodiments, each control stage in the plurality of control stages 203a, 203b, 203c comprises a control signal decoupling portion 206a, 206b, 206c to decouple the control signal received by each control stage from the control signal received by each other control stage.

In embodiments, each control stage 203a, 203b, 203c is configured to receive power through its power decoupling portion 205a, 205b, 205c, and to receive signals through its control signal decoupling portion 206a, 206b, 206c. Power supplied to each control stage in the plurality of control stages 203a, 203b, 203c is decoupled from power supplied to each other control stage in the plurality of control stages 203a, 203b, 203c.

In embodiments, the control signal decoupling portions 206a, 206b, 206c of the control stages are connected to a common signal input 207 such that all the control signal decoupling portions receive the same signal input. In alternative embodiments, some or all of the signal inputs may be connected to different signal inputs such that subsets of the control stages may receive different control signals.

In embodiments, at least one of the control signal decoupling portions 206a, 206b, 206c comprises a galvanic isolation device, for example, an opto-coupler, or a capacitive isolation device. In embodiments, each of the control signal decoupling portions 206a, 206b, 206c comprises a galvanic isolation device. In alternative embodiments, each control signal decoupling portion 206a, 206b, 206c comprises any components that electrically decouple the circuity of the control stages 203a, 203b, 203c from the circuitry of the common signal input 207.

In embodiments of the present disclosure, the plurality of FETs 201a, 201b, 201c are enhancement mode FETs and do not conduct current between their drain and source pins without a sufficient turn on voltage present at the gates 202a, 202b, 202c. However, it will be understood by the skilled person how embodiments of the present disclosure may be achieved with depletion mode FETs.

In embodiments each control stage 203a, 203b, 203c is configured to receive a control signal through its control signal decoupling portion 206a, 206b, 206c, instructing the control stages to provide a turn on voltage at the gate pin connections 204a, 204b, 204c to the gates 202a, 202b, 202c of the plurality of FETs to turn on the plurality of FETs. When control stages 203a, 203b, 203c provide a turn on voltage at the gate pin connection 204a, 204b, 204c, and thus gate pins 202a, 202b, 202c of the plurality of FETs, the plurality of FETs become conductive and may conduct current in parallel between the drain rail 218 and the source rail 219. In this manner the electrical power switching circuit may be considered to be switched on.

In embodiments where the control signal decoupling portions are all connected to a single common signal input 207, all control stages may turn on the plurality of FETs simultaneously. In embodiments, the control stages comprise a gate driver for supplying the turn on voltage to the gate pins 202a, 202b, 202c.

The plurality of FETs 201a, 202b, 202c continue to conduct while a voltage of at least the turn on voltage is present at the gate pins 202a, 202b, 202c of each FET in the plurality.

In an embodiment, the control stages 203a, 203b, 203c continue to supply a turn on voltage at the gate pin connections 204a, 204b, 204c while a turn on signal is present at the control signal decoupling portion. In an alternative embodiment, the control stages may provide a turn on voltage at the gate pin connections after a control signal is no longer present at the control signal decoupling portion, and continues to provide such a turn on voltage until a turn off signal is received. Upon removal of the turn on signal (or receipt of a turn off signal), the control stage stops supplying a turn on voltage at the gate pin connections 204a, 204b, 204c.

When the control stages 203a, 203b, 203c stop providing a turn on voltage at the gate pin connections 204a, 204b, 204c, and thus gate pins 202a, 202b, 202c of the FETs in the plurality, the plurality of FETs stop being conductive and do not conduct current between the drain rail 218 and source rail 219. In this manner the electrical power switching circuit may be considered to be switched off.

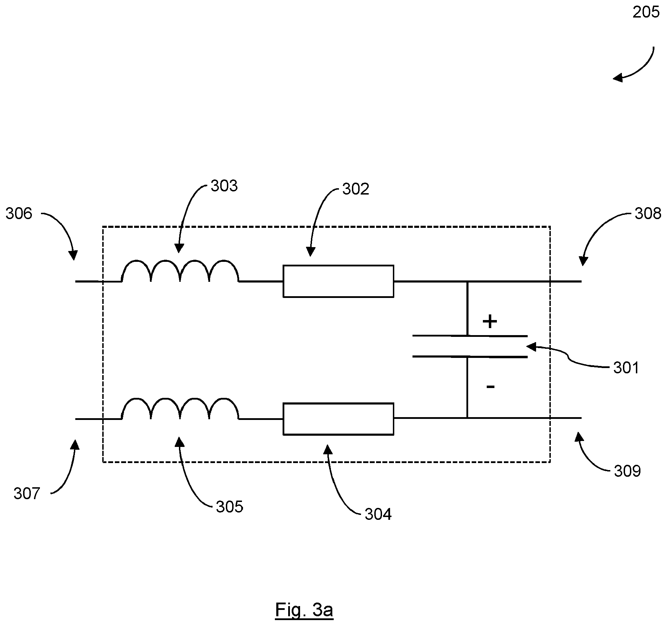

A power decoupling portion 205 according to embodiments of the present disclosure is shown in Figure 3a. In embodiments, the power decoupling portion comprises a positive supply resistor 302 and a positive supply inductor 303 connected in a series configuration with a positive terminal of a power supply capacitor 301, and a negative supply resistor 304 and a negative supply inductor 305 connected in a series configuration with a negative terminal of the power supply capacitor 301. In embodiments, the power decoupling portion comprises a positive input terminal 306 connected to the positive supply inductor 303, a positive output terminal 308 connected to the positive terminal of the power supply capacitor 301, a negative input terminal 307 connected to the negative supply inductor 305, and a negative output terminal 308 connected to the negative terminal of the power supply capacitor 301. In embodiments, the power supply capacitor 301 is connected across the positive output terminal 308 and the negative output terminal 309 between the resistors and output terminals.

In embodiments, the positive input terminal 306 and negative input terminal 307 are connected to a power supply. In embodiments, the power supplied to the power decoupling portion is provided through the common drain rail 218 and common source rail 219, respectively, via, for example, a step down converter. In other embodiments, the power to the positive input terminal 306 and negative input terminal 307 are connected to a different power supply.

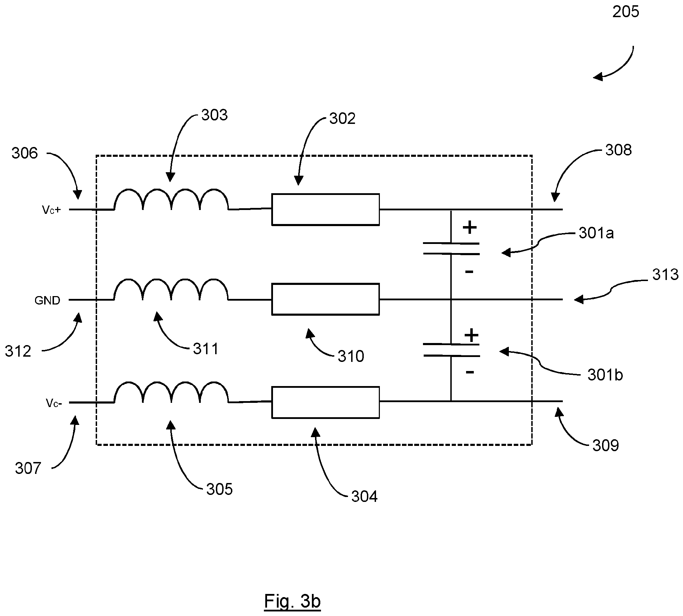

In other embodiments, the power decoupling portion comprises a first power decoupling capacitor 301a and a second power decoupling capacitor 301b connected in a series configuration, as shown in Figure 3b, in place of the single power decoupling power capacitor shown in Figure 3a. In embodiments, the power decoupling portion further comprises a ground resistor 310 and a ground inductor 311 connected in a series configuration with the connection point of the two series connected power supply resistors. In embodiments, the power decoupling portion further comprises a ground input terminal 312 connected to the ground inductor, and a ground output terminal 313 connected to the connection point of the two series connected power supply capacitors.

Referring to Figure 3a, when connected to an external power supply, a voltage is present across the power supply capacitor 301 (or capacitors 301a, 301b in the embodiment shown in Figure 3b) and the power supply capacitor is a store of energy. When energy is required by the control stages 203a, 203b, 203c to provide a turn on voltage at the gate pin connections, the power supply capacitor 301 of each power decoupling portion discharges to provide this energy. The power supply capacitor recharges to a suitable charge level to supply power for further switching operations in the time between switching operations. In other embodiments, the power is supplied by two power supply capacitors, as described in relation to Figure 3b.

The resistances and impedances of the power decoupling portion 205 decouple the power by limiting the DC and high frequency components, respectively, of any oscillating currents that occur during switch off of the plurality of FETs. By decoupling the power input to the control stages, any oscillating currents that arise during switch off of the plurality of FETs are prevented from circulating between gate driving paths of the FETs in the plurality and generating voltages at the gate pin connections of the control stages, and thus at the gate pins of the plurality of FETs, and prevent undesirable turn on of any of the plurality of FETs following a turn off event.

In embodiments, the control signal decoupling portions 206a, 206b, 206c of Figure 2 prevent circulating currents from signalling a control stage to turn on any of the FETs in the plurality. Common signal input 207 is decoupled from the control stages 203a, 203b, 203c and any circulating currents that may flow in the control stages do not affect the common signal input. As such, signals from the common signal input 207 that cause control stages 203a, 203b, 203c to operate the plurality of FETs are unaffected when the plurality of FETs turn off, and unintended operation of the control stages is eliminated.

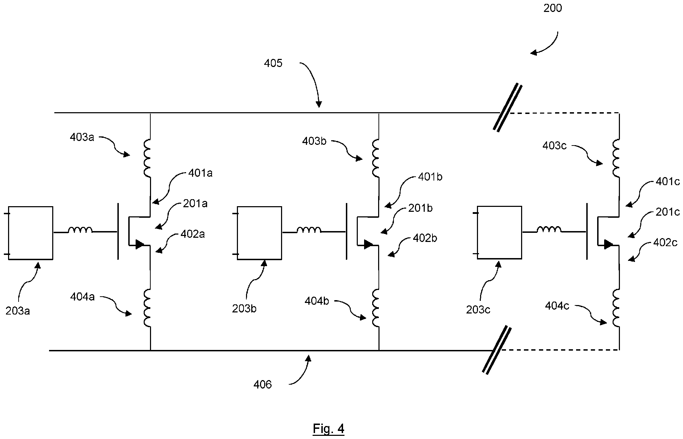

Figure 4 shows a further view of electrical power switching circuit 200, according to embodiments of the present disclosure. In these embodiments, each FET in the plurality of FETs comprises a drain pin 401a, 401b, 401c and a source pin 402a, 402b, 402c. In these embodiments, the electrical power switching circuit comprises a common drain conductor 405 and a common source conductor 406. The drain pin of each FET in the plurality of FETs is connected to the common drain conductor 405 and the source pin of each FET in the plurality of FETs is connected to the common source conductor 406. In embodiments, the common drain conductor is a drain busbar. In embodiments, the common source conductor is a source busbar.

In embodiments, each FET in the plurality further comprises a parasitic drain inductance 403a, 403b, 403c, each associated with the respective drain pin 401a, 401b, 401c of each FET in the plurality, and a parasitic source inductance 404a, 404b, 404c associated with the respective source pin 402a, 402b, 402c of each FET in the plurality. The parasitic inductances comprise inductances inherent in the plurality of FET devices and/or inductances inherent in the electrical connections and wiring of the circuit.

Schematically, each parasitic drain and source inductance is represented as a single inductor connected to the respective pin of a FET in the plurality of FETs. Figure 4 shows parasitic drain inductors 403a, 403b, 403c connected in a series configuration with the respective drain pins 401a, 401b, 401c, and parasitic source inductor 404a, 404b, 404c connected in a series configuration with the respective source pins 402a, 402b, 402c.

In order to share current equally through each parallel FET in the plurality, it is desirable that the sum of each drain and source impedance be equal, as discussed above in relation to prior art circuits. In embodiments, each FET in the plurality has a drain inductance, connected to its drain pin, and a source inductance, connected to its source pin. In embodiments, the drain inductance and the source inductance are deliberately provided in the FETs' drain and source connections. Thus, in embodiments, the drain and source inductances are not parasitic inductances and are not inherent to the FETs' source or drain pins. Thus, in embodiments, the source and drain inductances are separate from and in addition to any inherent inductances associated with the source and drain pins of the FETs. It may be that the drain and source inductances are each provided by the addition of an inductor or a ferrite bead. It may be that the drain and source inductances are provided by a PCB feature (for example, by deliberately lengthening the PCB tracks providing the FETs' drain and source connections). In embodiments of the present disclosure, the sum of the drain pin inductance and the source pin inductance of a first FET in the plurality of FETs is substantially equal to a sum of the drain pin inductance and the source pin inductance of a second FET in the plurality of FETs. In embodiments, the sum of the drain pin inductance and the source pin inductance of each FET in the plurality of FETs is substantially equal to a sum of the drain pin inductance and the source pin inductance of each other FET in the plurality of FETs. In embodiments, the source pin inductance of at least one FET in the plurality of FETs differs in value from that at least one other FET in the plurality. In embodiments, the source pin inductance of the at least one FET differs in value from that of each of the remaining FETs in the plurality. In embodiments, each of the FETs in the plurality of FETs has a source inductance which differs in value from the source inductances of the other FETs in the plurality. Thus, it may be that none of the FETs in the plurality have the same value of source inductance.

As the power and signal inputs are decoupled according to embodiments, circulating currents that arise during turn off of the plurality of FETs do not generate oscillating voltages at the gate pins of the FETs in the plurality, and do not cause the plurality of FETs to undesirably turn back on and as such, the parasitic source inductances of each parallel FET in the plurality may be different. This is in contrast to known prior art circuits, wherein all parasitic source inductances must be equal to all other parasitic source inductances. In embodiments, the circuit of the present disclosure is not constrained by the second design constraint referred to above in relation to known prior art circuits.

In embodiments, in the circuit of the present disclosure the sums of the parasitic source and drain inductances of each FET in the plurality are equal (403a+404a = 403b+404b = 403c+404c). In such embodiments, when the plurality of FETs are switched on, the current flowing through each parallel FET in the plurality of FETs during steady state conduction and during switching operations is substantially the same and switching losses are minimised. In embodiments, the individual parasitic drain inductances may be different (403a ≠ 403b ≠ 403c), and the individual parasitic source inductances may be different (404a ≠ 404b ≠ 404c).

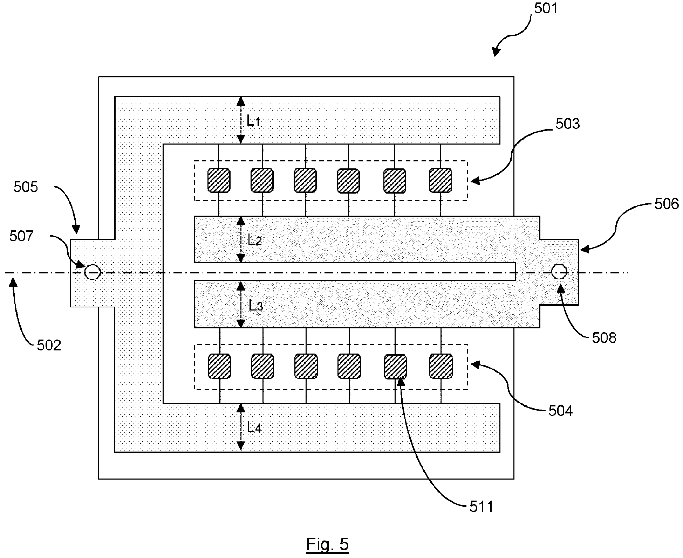

Figure 5 shows an electrical power switching circuit arranged on a PCB 501 in accordance with embodiments of the present disclosure. PCB 501 comprises a common drain conductor 505 and a common source conductor 506 and a plurality of FETs 511. In embodiments, the common conductors are busbars. In embodiments, the gate pin (not shown) of each FET in the plurality is connected to a respective control stage (not shown). Figure 5 shows twelve FETs arranged on the PCB 501, but it is to be understood that in other embodiments, more of fewer FETs may be used.

In embodiments, the plurality of FETs are arranged in a linear formation on the PCB and the common drain conductor 505 and common source conductor 506 are both symmetrical about a linear axis 502 of the linear formation of the plurality of FETs.

In embodiments, the plurality of FETs conduct a combined total current that is low enough to be conducted through PCB traces and in such embodiments the circuit may not comprise busbars. In other embodiments, the plurality of FETs conduct a combined total current that is too high to be conducted through PCB traces and the circuit comprises busbars.

In embodiments, a first subset of the plurality of FETs is arranged in a first linear formation 503 and a second subset of the plurality of FETs is arranged in a second linear formation 504, the first linear formation being oriented parallel to the second linear formation on the PCB. The source busbar 506 is mounted between the first linear formation 503 and second linear formation 504. The formations could comprise, for example, rows. The source pins of the plurality of FETs connect to the source busbar 506. The source busbar further comprises a source connection point 508 for connecting the busbar to external circuitry.

In embodiments, drain busbar 505 is a 'U' shaped busbar extending around the plurality of FETs and source busbar 506. The drain busbar 505 comprises an open end and a closed end, and two parallel sides extending either side of the first and second linear formations 503, 504 of FETs. The source busbar 506 extends into the open end of the drain busbar 505, and the drain busbar 505 comprises a drain connection point 507 along its closed end, opposite the source connection point 508. The drain pins of the plurality of FETs connect to the drain busbar. In embodiments, the source busbar 506 is also 'U' shaped and comprises a closed end, an open end and two parallel sides extending in between the first and second linear formations 503, 504 of FETs. The source busbar comprises an open end adjacent the closed end of the drain busbar, and a closed end adjacent the open end of the drain busbar. In embodiments, the connection point 508 of the source busbar is located on the closed end of the source busbar.

In embodiments, the two parallel sides of the drain busbar and the two parallel sides of the source busbar are all the same width, when measured along an axis perpendicular to the linear axis 502, as shown in Figure 5, wherein lengths L₁, L₂, L₃, and L₄ are the same.

In embodiments, the linear formations of FETs 503, 503 are arranged symmetrically about the linear axis 502. In embodiments the drain busbar 505 and source busbar 506 are arranged symmetrically about the linear axis 502.

In embodiments, the PCB does not comprise busbars and the drain pins and source pins of the plurality of FETs connect to common drain and source traces, respectively, that are printed, etched, or otherwise formed onto the PCB.

The control stages (not shown) connected to each FET in the plurality are further connected to a common control signal input to enable turn on and turn off of all FETs in the plurality simultaneously. In embodiments, the power supplied to the control stages is supplied through the busbars. In other embodiments, the power supplied to the control stages is supplied by a separate power circuit.

In embodiments, the drain busbar may extend along the centre of the PCB and the source busbar may extend around the plurality of FETs.

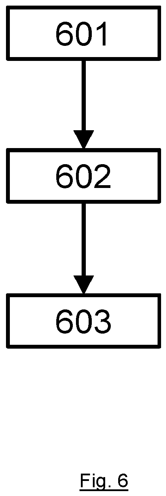

Figure 6 shows a method of manufacturing an electrical power switching circuit according to embodiments of the present disclosure.

In step 601, a plurality of FETs are formed in a parallel configuration, each FET in the plurality of FETs comprising a gate pin.

In step 602, a control stage is formed to each FET in the plurality of FETs, each control stage comprising a gate pin connection. Each control stage comprises a power decoupling portion to decouple the power supplied to each control stage from the power supplied to each other control stage.

In step 603, the gate pin of each FET in the plurality of FETs is connected to the gate pin connection of a respective control stage.

There is provided, according to embodiments of the present disclosure, a solid state relay comprising a plurality of field effect transistors, FETs, connected in a parallel configuration, each FET in the plurality of FETs comprising a gate pin. The solid state relay further comprises a plurality of control stages, each control stage in the plurality of control stages being associated with a FET in the plurality of FETs, each control stage in the plurality of control stages comprising a gate pin connection, wherein the gate pin of each FET in the plurality of FETs is connected to the gate pin connection of a respective control stage. Power supplied to each control stage in the plurality of control stages is decoupled from power supplied to each other control stage in the plurality of control stages.

Whilst the present disclosure has been described and illustrated with reference to particular embodiments, it will be appreciated by those of ordinary skill in the art that the present disclosure lends itself to many different variations not specifically illustrated herein. By way of example only, certain possible variations will now be described.

In embodiments, each FET in the plurality of FETs comprises a MOSFET. In other embodiments, each FET in the plurality of FETs comprises a MOSFET, and at least one MOSFET in the plurality of MOSFETs comprises an enhancement mode MOSFET. In other embodiments, each FET in the plurality of FETs comprises a MOSFET, and at least one MOSFET in the plurality of MOSFETs comprises a silicon MOSFET.

In embodiments, each control stage is connected to a subset of the FETs in the plurality of FETs such that each control stage controls two or more FETs in the plurality.

In embodiments, a subset of the control signal decoupling stages receive separate control signals such that the subset of control stages can operate independently of other control stages, and a corresponding subset of the plurality of FETs can operate independently of the other FETs in the plurality.

In embodiments, a plurality of FETs arranged on a PCB are arranged in three or more parallel formations. In other embodiments, the plurality of FETs are arranged in any linear pattern. In embodiments, the electrical power switching circuit is mounted on a PCB 501; the drain busbar 505 and source busbar 506 may for example have shapes that are symmetrical about a linear axis.

In embodiments, the power supply for the power supplied to the control stage to power switching operations is inductive.

In other embodiments, the control stages comprise any circuitry that is capable of supplying a sufficient turn on voltage to the gate pin of the plurality of FETs.

In embodiments, the electrical power switching circuit comprises a temperature regulation device.

In embodiments, the electrical power switching circuit is connected to a temperature regulation device.

Where in the foregoing description, integers or elements are mentioned which have known, obvious or foreseeable equivalents, then such equivalents are herein incorporated as if individually set forth. Reference should be made to the claims for determining the true scope of the present disclosure, which should be construed so as to encompass any such equivalents. It will also be appreciated by the reader that integers or features of the present disclosure that are described as preferable, advantageous, convenient or the like are optional and do not limit the scope of the independent claims. Moreover, it is to be understood that such optional integers or features, whilst of possible benefit in some embodiments of the present disclosure, may not be desirable, and may therefore be absent, in other embodiments.

## Claims

1. An electrical power switching circuit comprising:
a plurality of field effect transistors, FETs, connected in a parallel configuration, each FET in the plurality of FETs comprising a gate pin; and
a plurality of control stages, each control stage in the plurality of control stages being associated with a FET in the plurality of FETs, each control stage in the plurality of control stages comprising a gate pin connection, wherein the gate pin of each FET in the plurality of FETs is connected to the gate pin connection of a respective control stage,
wherein power supplied to each control stage in the plurality of control stages is decoupled from power supplied to each other control stage in the plurality of control stages.

2. An electrical power switching circuit according to claim 1, wherein each control stage in the plurality of control stages comprises a power decoupling portion to decouple the power supplied to each control stage from the power supplied to each other control stage.

3. An electrical power switching circuit according to claim 2, wherein:
each power decoupling portion comprises a power supply capacitor to provide a switching power to a respective control stage; and
each power decoupling portion comprises a first resistor and a first inductor connected in a series configuration with a positive terminal of the respective power supply capacitor, and a second resistor and a second inductor connected in a series configuration with a negative terminal of the respective power supply capacitor.

4. An electrical power switching circuit according to any preceding claim, wherein each control stage in the plurality of control stages is configured to receive a control signal, and wherein each control stage in the plurality of control stages is configured to provide a switching voltage at the gate pin of its associated FET upon receipt of the respective control signal.

5. An electrical power switching circuit according to claim 4, wherein each control stage in the plurality of control stages comprises a control signal decoupling portion to decouple the control signal received by each control stage from the control signal received by each other control stage.

6. An electrical power switching circuit according to claim 5, wherein at least one of the control signal decoupling portions comprises a galvanic isolation device.

7. An electrical power switching circuit according to any preceding claim, wherein each FET in the plurality of FETs further comprises:
a drain pin; and
a source pin,
and the electrical power switching circuit further comprises:
a common drain conductor; and
a common source conductor,
wherein the drain pin of each FET in the plurality of FETs is connected to the common drain conductor and the source pin of each FET in the plurality of FETs is connected to the common source conductor.

8. An electrical power switching circuit according to claim 7, wherein the plurality of FETs are arranged in a linear formation on the printed circuit board, and the common drain conductor and common source conductor are both symmetrical about an axis of the linear formation of the plurality of FETs.

9. An electrical power switching circuit according to any preceding claim, wherein each FET in the plurality of FETs comprises:
a drain pin inductance connected to a drain pin of the FET; and
a source pin inductance connected to a source pin of the FET,
wherein a sum of the drain pin inductance and the source pin inductance of a first FET in the plurality of FETs is substantially equal to a sum of the drain pin inductance and the source pin inductance of a second FET in the plurality of FETs.

10. An electrical power switching circuit according to claim 9, wherein the sum of the drain pin inductance and the source pin inductance of each FET in the plurality of FETs is substantially equal to a sum of the drain pin inductance and the source pin inductance of each other FET in the plurality of FETs.

11. An electrical power switching circuit according to claim 9 or 10, wherein the source pin inductance of at least one FET in the plurality of FETs differs from the source pin inductance of at least one other FET in the plurality.

12. An electrical power switching circuit according to any preceding claim, wherein the plurality of FETs are arranged in a linear formation on a printed circuit board.

13. An electrical power switching circuit according to claim 12, wherein a first subset of the plurality of FETs is arranged in a first linear formation and a second subset of the plurality of FETs is arranged in a second linear formation, the first linear formation being oriented parallel to the second linear formation on the printed circuit board.

14. A method of manufacturing an electrical power switching circuit, the method comprising:
forming a plurality of field effect transistors, FETs, in a parallel configuration, each FET in the plurality of FETs comprising a gate pin;
forming a control stage to each FET in the plurality of FETs, each control stage comprising a gate pin connection; and
connecting the gate pin of each FET in the plurality of FETs to the gate pin connection of a respective control stage,
wherein each control stage comprises a power decoupling portion to decouple power supplied to each control stage from power supplied to each other control stage.

15. A solid state relay comprising:
a plurality of field effect transistors, FETs, connected in a parallel configuration, each FET in the plurality of FETs comprising a gate pin; and
a plurality of control stages, each control stage in the plurality of control stages being associated with a FET in the plurality of FETs, each control stage in the plurality of control stages comprising a gate pin connection, wherein the gate pin of each FET in the plurality of FETs is connected to the gate pin connection of a respective control stage,
wherein power supplied to each control stage in the plurality of control stages is decoupled from power supplied to each other control stage in the plurality of control stages.
